Europäisches Patentamt

European Patent Office

Office européen des brevets

(11) Veröffentlichungsnummer: **0 454 012 A2**

(12) **EUROPÄISCHE PATENTANMELDUNG**

(21) Anmeldenummer: 91106412.9

(22) Anmeldetag: 22.04.91

(51) Int. Cl.5: **G01R 27/00**

(30) Priorität: 27.04.90 DE 4013490

(43) Veröffentlichungstag der Anmeldung:
30.10.91 Patentblatt 91/44

(84) Benannte Vertragsstaaten:
AT CH DE FR GB LI

(71) Anmelder: **ABB PATENT GmbH**
**Kallstadter Strasse 1**
**W-6800 Mannheim 31(DE)**

(72) Erfinder: **Ziegler, Herbert**
**Hartensteiner Strasse 66**
**W-8500 Nürnberg(DE)**
Erfinder: **Kindermann, Robert**
**Brettergartenstrasse 9**
**W-8500 Nürnberg(DE)**

(74) Vertreter: **Rupprecht, Klaus, Dipl.-Ing. et al**
**c/o ABB Patent GmbH, Patentabteilung,**
**Postfach 10 03 51**
**W-6800 Mannheim 1(DE)**

(54) **Prüfgerät mit einer Gleichstromquelle.**

(57)
2.1 Zur Messung des Widerstandes von Schutzleitern und Potentialausgleichsleitungen benötigt man eine Gleichspannungsquelle, um den erforderlichen Meßstrom zu erzeugen. Die Bauelemente der Schaltungsanordnung sollen dabei vor gefährlichen Fremdspannungen geschützt werden, die bei Fehlbedienung auftreten können ohne daß im Fehlerfall Teile der Schutzschaltung, wie z.B. Schmelzsicherungen ausgewechselt werden müssen.

2.2 Auf der einen Seite des Meßobjektes ($R_x$) wird eine Sperrdiode ($V_4$) und auf der anderen Seite ein gesteuerter Halbleiterschalter ($V_8$) in den Stromkreis eingefügt. Eine den Halbleiterschalter ($V_8$) steuernde Steuerschaltung (L) ist so ausgelegt, daß sie über den Halbleiterschalter ($V_8$) den Stromkreis sperrt, sobald die durch die Gleichspannungsquelle ($U_0$) und die Fremdspannung gebildete Summenspannung die Schwellwertspannung eines zur Steuerschaltung (L) gehörigen Schwellwertelementes ($V_5$) überschreitet.

2.3 Das Prüfgerät soll zur Messung eines Widerstandes, insbesondere des Widerstandes von Schutzleitern und Potentialausgleichsleitungen dienen.

Die Erfindung betrifft ein Prüfgerät der in Oberbegriff des Anspruchs 1 genannten Art.

Prüfgeräte, die zur Messung ohmscher Widerstände dienen sollen, benötigen eine Gleichspannungquelle, von der ein Strom über das Meßobjekt geleitet wird, so daß ein Spannungsabfall entsteht, mit dessen Hilfe der Widerstand des Meßobjektes ermittelt werden kann. Bei separaten Bauteilen, deren Widerstandswert z.B. vor dem Einbau in eine Schaltungsanordnung überprüft werden muß, ist diese Messung völlig unproblematisch. Anders liegen die Verhältnisse dagegen, wenn das Meßobjekt bereits in einen Schaltungsaufbau integriert ist und mit gefährlichen Fremdspannungen zu rechnen ist. Dies gilt grundsätzlich z.B. bei Schutzleitern und Potentialausgleichsleitungen in Wechselstromnetzen, deren Widerstand zu messen ist.

Nach VDE 0413 ist vorgeschrieben, daß derartige Messungen mit einem Meßstrom von mindestens 0,2 A und einer treibenden Spannung von mindestens 4,5 V durchgeführt werden. Ferner ist festgelegt, daß die hierzu benutzten Prüfgeräte bei Fehlbedienung weder zerstört werden noch den Benutzer gefährden dürfen. Das Prüfgerät muß dementsprechend so aufgebaut sein, daß eine durch Fehlbedienung an die Meßeingänge gelangende Netzspannung keinen Schaden verursacht.

Es ist bekannt, Prüfgeräte eingangsseitig durch Leistungsdioden in Verbindung mit einer Schmelzsicherung zu schützen. Die Schmelzsicherung ist hierbei in Reihe zu dem Meßeingang geschaltet und wird zusammen mit diesem durch eine Diodenkette überbrückt. Die von der Diodenkette erreichte Schwellwertspannung liegt über dem Spannungswert der Gleichspannungsquelle, so daß dieser und damit auch der über das Meßobjekt zu leitende Meßstrom unbeeinflußt bleiben. Größere, sich zur Gleichspannung addierende Fremdspannungen werden dagegen praktisch kurzgeschlossen. Der Kurzschlußstrom wiederum bringt die Schmelzsicherung zum Ansprechen, so daß die gefährliche Fremdspannung von der Gleichspannungsquelle getrennt wird und deren Bauteile nicht mehr zerstören kann.

Eine derartige Anordnung ist jedoch insofern unbefriedigend, weil jede Fehlbedienung durch die eine gefährliche Fremdspannung an die Meßeingänge gelangt, die Schmelzsicherung auslöst. Das Prüfgerät ist dann erst nach einem Sicherungswechsel wieder betriebsbereit. Ersatzsicherungen müssen deshalb jederzeit zur Verfügung stehen. Ferner ist nachteilig, daß die aus Leistungsdioden bestehende Diodenkette und der zur Aufnahme der Sicherung benötigte Sicherungshalter viel Platz beanspruchen.

Aufgabe der Erfindung ist es deshalb, ein der Gattung des Anspruchs 1 entsprechendes Prüfgerät zu schaffen, das eine gefährliche Fremdspannung so abblockt, daß sie weder das Gerät noch die bedienende Person gefährden kann, die Blockade aber selbsttätig wieder aufhebt und die Messung fortsetzt, sobald die gefährliche Fremdspannung beseitigt ist.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Durch die Erfindung gelingt es, mit einfachen Mitteln Fremdspannungen, die einen gefährlichen Wert übersteigen, unabhängig von ihrer Polarität von der Gleichspannungsquelle fernzuhalten. Zum Abblocken von gegenüber der Gleichspannungsquelle gegenpoligen Fremdspannungen genügt bereits der Einbau einer Sperrdiode. Zu Abwehr gleichpoliger Fremdspannungen ist dagegen ein Halbleiterschalter erforderlich, der so gesteuert wird, daß seine Schaltstrecke bei fehlender Fremdspannung immer geschlossen bleibt und der für die Messung erforderliche Meßstrom somit fließt, die Schaltstrecke des Halbleiterschalters dagegen sperrt, sobald eine aus der Gleichspannungsquelle und der Fremdspannung gebildete Summenspannung die Schwellspannung eines Schwellwertelementes überschreitet. Das Schwellwertelement ist Teil einer Steuerschaltung, die einerseits die Summenspannung überwacht und andererseits den Halbleiterschalter steuert.

Verwendet man zur Widerstandsmessung einen Konstantstrom, dessen Wert bekannt ist, so ergibt sich eine wesentliche Vereinfachung des Meßablaufs, da der am Meßobjekt erzeugte Spannungsabfall bereits eine seinem Widerstand proportionale Größe darstellt. Es ist deshalb zweckmäßig auch ein zur Überprüfung von Schutzleitern und Potentialausgleichsleitungen dienendes Prüfgerät mit einer Konstantstromquelle zu versehen. Eine sehr vorteilhafte Weiterbildung des Erfindungsgegenstandes sieht nunmehr vor, daß ein als Stellelement in einer Konstantstromquelle benötigter Halbleiterschalter gleichzeitig auch die Funktion als Sperrschalter zum Abblocken gefährlicher Fremdspannungen übernimmt.

Die zur Erzeugung des Konstantstromes benötigte Regelschaltung ist in zweckmäßiger Weise so aufgebaut, daß der invertierende Eingang eines Regelverstärkers an einem mit der Schaltstrecke des Halbleiterschalters in Reihe liegenden Stromgegenkopplungswiderstand liegt und die an ihm abfallende Gegenkopplungsspannung mit einer an einem Referenzelement erzeugten, dem nicht invertierenden Eingang des Regelverstärkers zugeführten Referenzspannung vergleicht und den Steuereingang des Halbleiterschalters mit einem entsprechenden Ausgangssignal beaufschlagt.

Weiterhin ist die in die Regelschaltung integrierte Steuerschaltung so aufgebaut, daß ein Steuertransistor mit seiner Kollektoremitterstrecke zwischen den Steuereingang des Halbleiterschalters und dem von diesem abgewandten Ende des Stromgegenkopplungswiderstandes liegt und seine Basis mit einem Spannungsteiler verbunden ist, der mit dem Schwellwertelement der Regelschaltung in Reihe liegt und dieser Spannungsteiler die Schaltstrecke des Halbleiterschalters mit dem in Reihe liegenden Stromgegenkopplungwiderstand überbrückt.

Parallel zu der aus der Schaltstrecke des Halbleiterschalters und dem Stromgegenkopplungswiderstand gebildeten Reihenschaltung ist ein Varistor angeordnet, der den Halbleiterschalter vor Überspannungsspitzen schützt.

Die aus Gleichspannungsquelle und Regelschaltung gebildete Konstantstromquelle hat im Rahmen der mit dem Prüfgerät durchzuführenden Messung nur einen Konstantstrom zu erzeugen, der am Meßobjekt einen Spannungsabfall hervorruft. Die Messung dieses Spannungsabfalls muß nun mit Hilfe einer Meßschaltung erfolgen, die den gemessenen Wert entsprechend auswertet und gegebenenfalls zu Anzeige bringt. Als Halbleiterschalter dient zweckmäßigerweise ein Leistungstransistor, der vorzugsweise als FET aufgebaut ist, wobei die Drain-Source-Strecke als Schaltstrecke und das Gate als Steuereingang wirken.

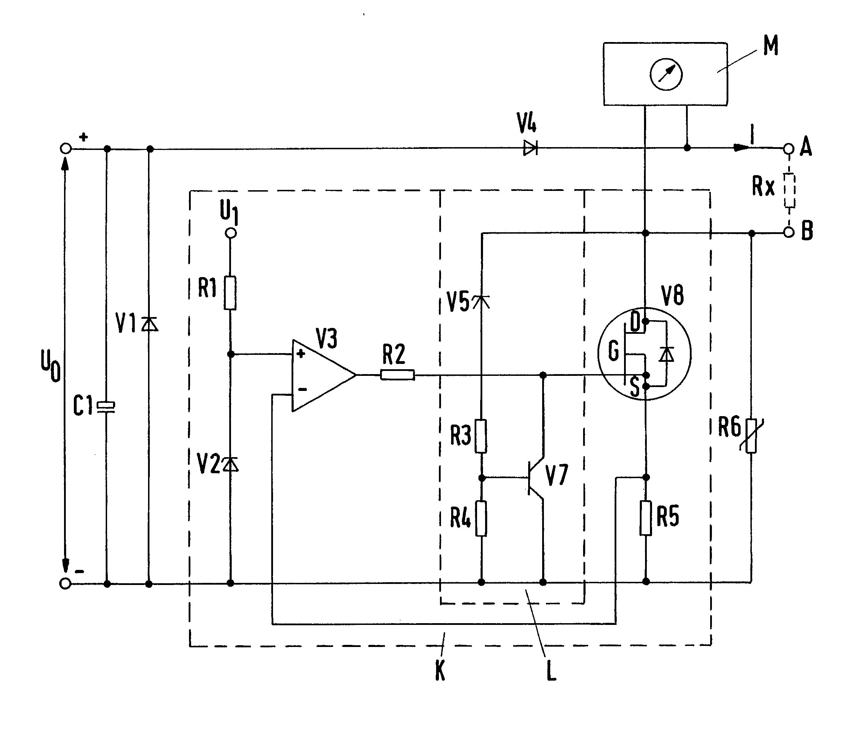

Ein Ausführungsbeispiel der Erfindung ist in der Zeichnung dargestellt und wird im folgenden näher beschrieben.

Wie die Zeichnung erkennen läßt, besitzt die Schaltungsanordnung des Prüfgerätes eine Gleichspannungsquelle $U_0$, die eine zur Erzeugung eines Konstantstromes I dienende Regelschaltung K speist, und diesen Strom I als Meßstrom an den Eingangsklemmen A und B bereitstellt. Der konstante Meßstrom I durchfließt ein Meßobjekt $R_x$, und erzeugt an dessen Widerstand einen Spannungsabfall, der durch eine Meßschaltung M erfaßt und ausgewertet wird.

Werden die Meßeingänge A,B versehentlich nicht mit einem zu überprüfenden Schutzleiter verbunden, sondern gelangen sie durch einen Bedienungsfehler an einen Phasenleiter, so soll die hierdurch entstehende Fremdspannung durch die Schaltungsanordnung abgeblockt werden. Zur Unterdrückung gegenpoliger Fremdspannungen ist eine Serrdiode $V_4$ zwischen einen ersten Meßeingang A und den positiven Pol der Gleichspannungsquelle $U_0$ so geschaltet, daß sie in entgegengesetzter Richtung zur Gleichspannungsquelle fließende Ströme sperrt. Wechselt jedoch die Polarität der an den Meßeingängen A,B anliegenden Fremdspannung, so liegt nunmehr diese Spannung mit gleicher Polarität in Reihe zur Gleichspannungsquelle $U_0$, so daß eine über deren Spannungswert weit hinausgehende Summenspannung entsteht. Diese würde an bestimmten im Stromkreis liegenden Bauelementen eine unzulässig hohe Verlustleistung verursachen, die zu einer Zerstörung dieser Bauelemente führen könnte, was verhindert werden muß.

Zwischen den zweiten Meßeingang B und den negativen Pol der Gleichspannungsquelle $U_0$ ist die Schaltstrecke D-S eines als FET aufgebauten Leistungstransistors $V_8$ und ein hierzu in Reihe liegender Stromgegenkopplungswiderstand $R_5$ in den Stromkreis eingefügt. Die Schaltstrecke D-S des Leistungstransistors $V_8$ kann über einen Steuereingang G geschlossen oder zum Unterbrechen des Stromkreises geöffnet werden. Hierzu wird der Steuereingang G vom Ausgangssignal der Regelschaltung K beaufschlagt.

Die Regelschaltung K besitzt einen Regelverstärker $V_3$, der den seinem invertierenden Eingang (-) zugeführten, am Stromgegenkopplungswiderstand $R_5$ abgegriffenen Spannungsabfall mit einer seinem nichtinvertierenden Eingang (+) zugeführten Referenzspannung vergleicht und den als Stellelement wirkenden Halbleiterschalter $V_8$ so steuert, daß sich der Stromfluß im Sinne einer Konstanthaltung des Meßstromes I erhöht oder verringert. Die Referenzspannung wird durch ein Referenzelement $V_2$ erzeugt, das über einen Vorwiderstand $R_1$ an einer Hilfsspannung $U_1$ anliegt.

In die Regelschaltung K integriert, aber in ihre Funktion von dieser völlig unabhängig, ist eine Steuerschaltung L, die wiederum ein Referenzelement $V_5$ aufweist, das mit zwei Spannungsteilerwiderständen $R_3$, $R_4$ in Reihe liegt, und insgesamt eine zur Reihenschaltung der Schaltstrecke D-S des Halbleiterschalters $V_8$ und dem Gegenkopplungswiderstand $R_5$ parallelliegende Reihenschaltung bildet. Ein mit seiner Basis am Spannungsteiler $R_3$,$R_4$ liegender Transistor $V_7$ überbrückt mit seiner Emitterkollektorstrecke den Steuereingang des Halbleiterschalters $V_8$ zum negativen Potential der Hilfsspannungsquelle $U_0$ hin, an dem auch der

Spannungsteilerwiderstand $R_4$ und der Stromgegenkopplungswiderstand $R_5$ liegen.

Die Steuerschaltung L kann auch ohne die zur Konstantstromregelung dienenden Elemente der Regelschaltung K, alleine in Verbindung mit der Gleichspannungsquelle $U_0$ eingesetzt werden. In diesem Fall wird lediglich ein Spannungsteiler benötigt, durch den eine Vorspannung an das Gate G des Halbleiterschalters $V_8$ gelangt, die dafür sorgt, daß die Schaltstrecke D-S bei fehlender Fremdspannung geschlossen bleibt.

Zur Erläuterung der übrigen Bauelemente der Schaltungsanordnung ist noch zu sagen, daß ein Widerstand $R_6$ als Varistor arbeitet, der bei Überspannungsspitzen einen niederohmigen Wert annimmt und dadurch den Halbleiterschalter $V_8$ schützt. Ein Kondensator C1 gehört zur ungeregelten Gleichspannungsquelle $U_0$ und dient hier als Siebkondensator. Eine dazu parallelliegende Diode $V_1$, die in der gleichen Richtung, wie die Diode $V_4$ gepolt ist, schließt sehr schnelle Fremdspannungsspitzen, die durch den Halbleiterschalter nicht sofort unterdrückt werden, zum Schutz der Gleichspannungsquelle $U_0$ kurz. Ein zwischen dem Ausgang des Regelverstärkers $V_3$ und dem Gate G des Halbleiterschalters $V_8$ liegender Widerstand $R_2$ dient zur Strombegrenzung.

Während also bei positivem Potential am Meßeingang A die Diode $V_4$ den Stromfluß der Fremdspannung sperrt und damit die Schaltungsteile vor Zerstörung bewahrt, übernimmt bei negativem Potential der Fremdspannung am Meßeingang A der Halbleiterschalter $V_8$ die Sperrfunktion. Dies gelingt mit Hilfe der Steuerschaltung L, bei der das Referenzelement $V_5$ so dimensioniert ist, daß die Zenerspannung knapp über der maximalen Versorgungsspannung der Gleichspannungsquelle $U_0$ liegt. Sobald also die sich aus der Gleichspannung $U_0$ und der Fremdspannung bildende Summenspannung die Zenerspannung überschreitet, fließt ein Strom über den Spannungsteiler $R_3, R_4$, wodurch positives Potential an die Basis des Steuertransistors $V_7$ gelangt, der seinerseits das Gate G des Halbleiterschalters $V_8$ auf Minuspotential zieht. Die im Normalfall geschlossene Schaltstrecke D-S des Halbleiterschalters $V_8$ wird somit nunmehr geöffnet, wodurch sie den weiteren Stromfluß sperrt. Der Widerstand $R_3$ und der Halbleiterschalter $V_8$ sind spannungsfest für die maximale Fremdspannung. Nach Beseitigung der Fremdspannung ist die Konstantstromquelle wieder betriebsbereit.

**Patentansprüche**

1. Prüfgerät mit einer Gleichspannungsquelle zur Erzeugung eines über ein Meßobjekt zu leitenden Meßstromes, insbesondere zur Messung des Widerstandes von Schutzleitern und Potentialausgleichsleitungen, und mit einer Schutzschaltung zur Abwehr gefährlicher über das Meßobjekt eingeschleifter Fremdspannungen, dadurch gekennzeichnet, daß zum Abblocken gegenpoliger Fremdspannungen an einer Seite des Meßobjektes ($R_x$) in den Stromkreis zwischen ihm und die Gleichspannungsquelle ($U_0$) eine Sperrdiode ($V_4$) eingefügt ist und zur Unterdrückung gleichpoliger in Reihe liegender Fremdspannungen an der anderen Seite des Meßobjektes ($R_x$) in den Stromkreis zwischen ihm und der Gleichspannungsquelle ($U_0$) ein gesteuerter Halbleiterschalter ($V_8$) eingefügt ist, und eine den Halbleiterschalter ($V_3$) steuernde Steuerschaltung (L) so ausgelegt ist, daß dieser den Stromkreis sperrt, sobald die durch die Gleichspannungsquelle ($U_0$) und die Fremdspannung gebildete Summenspannung die Schwellwertspannung eines zur Steuerschaltung (S) gehörigen Schwellwertelementes ($V_5$) überschreitet, wobei die Schwellwertspannung größer als die Spannung der Gleichspannungsquelle ($U_0$) ist und die Schaltstrecke (D-S) des Halbleiterschalters ($V_8$) sich wieder schließt, sobald die Summenspannung die Schwellwertspannung unterschreitet.

2. Prüfgerät nach Anspruch 1, dadurch gekennzeichnet, daß der steuerbare Halbleiterschalter ($V_8$) neben seiner Funktion als Sperrschalter gleichzeitig als Stellelement in einer einen Konstantstrom erzeugenden Regelschaltung (K) dient.

3. Prüfgerät nach Anspruch 2, dadurch gekennzeichnet, daß die Regelschaltung (K) einen Regelverstärker (V8) besitzt, der mit seinem invertierenden Eingang (-) an einem mit der Schaltstrecke (D-S) des Halbleiterschalters ($V_8$) in Reihe liegenden Stromgegenkopplungswiderstand ($R_5$) liegt und die an ihm abfallende Gegenkopplungsspannung mit einer an einem weiteren Referenzelement ($V_2$) erzeugten, seinem nichtinvertierenden Eingang (+) zugeführten Referenzspannung vergleicht und den Steuereingang (G) des Halbleiterschalters ($V_8$) mit einem entsprechenden Ausgangssignal beaufschlagt.

4. Prüfgerät nach einem der vorhergehenden Ansprüche, dadurch gekennzeichnet, daß die Steuerschaltung (L) einen Steuertransistor ($V_7$) beinhaltet, der mit seiner Kollektor/Emitter-Strecke zwischen dem Steuereingang des Halbleiterschalters ($V_8$) und dem von diesem abgewandten Ende des Stromgegenkopplungswiderstandes ($R_5$) liegt und dessen Basis mit einem Spannungsteiler ($R_3,R_4$) verbunden ist, der mit dem Schwellwertelement ($V_5$) der Regelschaltung (S) in Reihe liegt und dieser Spannungsteiler ($R_3,R_4$) die Schaltstrecke (D-S) des Halbleiterschalters (V8) mit dem in Reihe liegenden Stromgegenkopplungswiderstand ($R_5$) überbrückt.

5. Prüfgerät nach einem der vorhergehenden Ansprüche, dadurch gekennzeichnet, daß parallel zu der aus der Schaltstrecke (D-S) des Halbleiterschalters ($V_8$) und dem Stromgegenkopplungswiderstand ($R_5$) gebildeten Reihenschaltung ein Varistor ($R_6$) angeordnet ist.

6. Prüfgerät nach einem der vorhergehenden Ansprüche, dadurch gekennzeichnet, daß am Ausgang (A,B) der durch die Sperrdiode ($V_4$), die Gleichspannungsquelle ($U_0$), den Stromgegenkopplungswiderstand ($R_5$) und die Schaltstrecke (D-S) des Halbleiterschalters ($V_8$) gebildeten Reihenschaltung das den Stromkreis schließende Meßobjekt ($R_x$) liegt und eine Meßschaltung (M) den an ihm erzeugten Spannungsabfall erfaßt und gegebenenfalls zu Anzeige bringt.

7. Prüfgerät nach einem der vorhergehenden Ansprüche, dadurch gekennzeichnet, daß als Halbleiterschalter ($V_8$) ein Leistungstransistor, vorzugsweise ein FET dient, dessen Drain/Source-Strecke (D-S) als Schaltstrecke und dessen Gate (G) als Steuereingang wirken.